# EUROPEAN PATENT SPECIFICATION

(11) **EP 1 830 431 B1**
(45) Date of publication and mention of the grant of the patent: **22.05.2013**
(21) Application number: 05814481.7
(22) Date of filing: 07.12.2005
(51) Int. Cl.: H01M 14/00, H01L 31/04

(54) **COUNTER ELECTRODE FOR PHOTOELECTRIC CONVERTER AND PHOTOELECTRIC CONVERTER**
GEGENELEKTRODE FÜR EINEN FOTOELEKTRISCHEN WANDLER UND FOTOELEKTRISCHER WANDLER
CONVERTISSEUR PHOTOELECTRIQUE ET SA CONTRE-ELECTRODE

(30) Priority: 22.12.2004 JP 2004371703; 26.09.2005 JP 2005278096
(43) Date of publication of application: 05.09.2007
(73) Proprietor: FUJIKURA LTD., Koto-ku Tokyo 135-8512 (JP)
(72) Inventor: USUI, Hiroki c/o Fujikura Ltd., Tokyo 1358512 (JP); TANABE, Nobuo c/o Fujikura Ltd., Tokyo 1358512 (JP); MATSUI, Hiroshi c/o Fujikura Ltd., Tokyo 1358512 (JP)
(74) Representative: Carter, Stephen John
(86) International application number: PCT/JP2005/022485
(87) International publication number: WO 2006/067969

(56) References cited:
- EP-A1- 1 357 607
- JP-A- 2004 111 216
- JP-A- 2004 241 228
- JP-A- 2004 288 985
- JP-A- 2004 319 661
- JP-A- 2004 319 661
- SUZUKI K ET AL: "APPLICATION OF CARBON NANOTUBES TO COUNTER ELECTRODES OF DYE-SENSITIZED SOLAR CELLS", CHEMISTRY LETTERS, CHEMICAL SOCIETY OF JAPAN, JP, vol. 32, no. 1, 1 January 2003 (2003-01-01), page 28/29, XP008025168, ISSN: 0366-7022, DOI: DOI:10.1246/CL.2003.28

## Description

### TECHNICAL FIELD

The present invention relates to a structure of a counter electrode for use in a photoelectric conversion element such as a Dye Sensitized Solar Cell.

### BACKGROUND ART

Solar cells as a source of clean energy have attracted attention against the backdrop of environmental issues and resource issues. Some solar cells use monocrystalline, polycrystalline, or amorphous silicon. However, conventional silicon-based solar cells have persistent problems such as high manufacturing costs and insufficient raw materials, and thus are yet in wide spread use.

In contrast to this, a Dye Sensitized Solar Cell, as proposed by Graetzel et al. in Switzerland, has been gained attention as a low-cost photoelectric conversion element capable of obtaining high conversion efficiency (for example, see Patent Document 1, Patent Document 2, Non-Patent Document 1, etc.).

Generally, a wet-type solar cell such as a Dye Sensitized Solar Cell (DSC) is schematically composed of: a working electrode in which a porous film made of oxide semiconductor fine particles (nanoparticles) such as titanium dioxide, on which a sensitizing element is adsorbed, is formed on one surface of a transparent base material made of a material excellent in light transmission such as glass; a counter electrode formed of a conductive film formed on one surface of a substrate made of an insulating material such as glass; and an electrolyte including redox pairs of iodine and the like, the electrolyte being encapsulated between the electrodes.
Patent Document 1: Japanese Patent No. 2664194
Patent Document 2: Japanese Unexamined Patent Application, First Publication No. 2001-160427
Non-Patent Document 1: M. Graetzel et al., Nature, p. 737-740, vol. 353, 1991

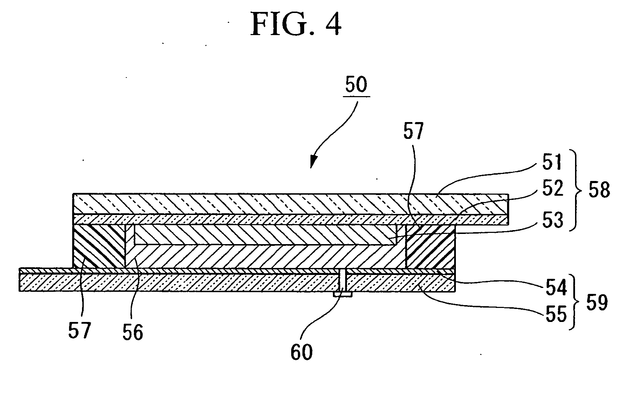

FIG. 4 shows a schematic cross-sectional view of one example of a structure of a conventional dye sensitized solar cell.

The dye sensitized solar cell 50 mainly comprises: a first substrate 51 on one surface of which is formed a porous semiconductor electrode (hereinafter, referred to as a dye sensitized semiconductor electrode or a working electrode) 53, a sensitizing element being adsorbed on the porous semiconductor electrode; a second substrate 55 formed with a conductive film 54; and an electrolyte layer 56 made of e.g. a gel-like electrolyte inserted between these.

As the first substrate 51, a light transmissive plate is used. On the surface of the dye sensitized semiconductor electrode 53 side of the first substrate 51, a transparent conductive film 52 is arranged allowing for conductivity. The first substrate 51, the transparent conductive film 52, and the dye sensitized semiconductor electrode 53 constitute a window electrode 58.

On the other hand, as the second substrate 55, a conductive transparent substrate or a metal substrate is used. To impart conductivity to the surface on the electrolyte layer 56 side, a conductive film 54 is provided, made of carbon or platinum, formed on a transparent conductive electrode substrate or a metal plate by means of deposition or sputtering. The second substrate 55 and the conductive film 54 constitute a counter electrode 59.

The window electrode 58 and the counter electrode 59 are spaced apart at a predetermined distance from each other such that the dye sensitized semiconductor electrode 53 faces the conductive film 54, and a. sealant 57 made of a heat-curing resin is provided in the peripheral region between the electrodes. The window electrode 58 and the counter electrode 59 are attached via the sealant 57 to assemble a cell. An electrolyte solution in which redox pairs of an iodine/iodide ion (I⁻/I³⁻) or the like as electrolyte are dissolved in an organic solvent such as acetonitrile is filled between the electrodes 58 and 59 through a fill port 60 for the electrolyte solution to form an electrolyte layer 56 for transferring electric charges.

Other than this structure, a structure that uses non-volatile ionic liquid, a structure in which a liquid electrolyte is gelled into a quasi-solidified substance by an appropriate gelling agent, a structure that uses a solid semiconductor such as a p-type semiconductor, etc. are known.

Ionic liquid, also called an ambient temperature molten salt, is a salt made only of positively and negatively charged ions that exists as stable liquid in the wide range of temperatures including the temperature around room temperature. This ionic liquid has substantially no vapor, thereby eliminating the possibility of evaporating or catching fire as is the case with a general organic solvent. Therefore, it is hoped that the ionic liquid will be a solution to decrease in cell characteristic due to volatilization.

This type of dye sensitized solar cell absorbs incident light such as of solar light, which causes light sensitizing dye to sensitize oxide semiconductor fine particles. This generates electromotive force between the working electrode and the counter electrode. Thus, the dye sensitized solar cell functions as a photoelectric conversion element for converting light energy into electric energy.

To improve power generation efficiency of a dye sensitized solar cell, it is necessary to make the transfer of electrons from the counter electrode to the electrolyte faster. With the counter electrode using a conventional, typical carbon film or platinum film, the transfer speed of electrons is low. Therefore, power generation efficiency is susceptible to improvement in many ways.

"Application of Carbon Nanotubes to Counter Electrodes of Dye-sensitized Solar Cells" (Suzuki et al., Chemistry Letters Vol. 32, No.1 (2003)) discloses the use of three kinds of nano-carbon materials in dye-sensitized solar cells, including single wall carbon nanotubes, carbon filament and nanohorn.

EP 1,357,607A discloses a solar cell which is claimed to have an improved processibility suitable for industrial-scale and which is easily prepared at a lower cost. The solar cell comprises a pair of substrates which each has at least two insulatedly divided transparent electrically-conductive film layer regions and at least one semiconductor layer placed partially and stackingly on at least one of the transparent electrically-conductive film layer regions, wherein a transparent electrically-conductive film layer and a semiconductor layer, that are positioned on the same transparent electrically-conductive film layer region placed on one substrate, are respectively positioned so as to be opposed to a semiconductor layer positioned on a transparent electrically-conductor layer region on the other substrate and another transparent electrically-conductive film layer positioned on another transparent electrically-conductive film layer region placed on the other substrate.

JP 2004-319661 discloses a substrate for photoelectric conversion device which is equipped with tube type carbon making a porous layer wherein an external surface is covered with a titanium oxide film on a film formation surface of the substrate. The longitudinal direction of the tube type carbon is oriented almost perpendicularly to the film formation surface of the substrate.

### DISCLOSURE OF INVENTION

The present invention has been achieved in view of the above circumstances, and has an object to actualize a faster transfer of electrons from the counter electrode to the electrolyte.

To achieve the above object, a first aspect of the present invention is a solar cell, comprising: a window electrode having a transparent substrate and a semiconductor layer provided on a surface of the transparent substrate, a sensitizing dye being adsorbed on the semiconductor layer; a counter electrode having a substrate and a conductive film provided on a surface of the substrat or a counter electrode including a titanium plate, that is arranged so as to face the semiconductor layer of the window electrode; and an electrolyte layer disposed at least in a portion between the window electrode and the counter electrode, characterized in that: the counter electrode has brush-like carbon nanotubesthat are provided on the substrate surface via the conductive film, and the brush-like carbon nanotubes are oriented perpendicular to the substrate surface so as to directly connect to the electrolyte layer disposed between the brush-like carbon nanotubes.

In the first aspect of the present invention, the brush-like carbon nanotubes may be spaced 1 to 1000 nm apart.

In the first aspect of the present invention, the substrate used for the counter electrode may have the surface on which the conductive film and the carbon nanotubes are to be provided subjected to an oxidation treatment.

In the first aspect of the present invention, the semiconductor layer may be composed of a porous oxide semiconductor.

Configuring the above photoelectric conversion element as described above by use of the counter electrode configured as above improves electron emission capability of the counter electrode, allowing the electrolyte to find its way between the carbon nanotubes. Therefore, it is possible to obtain a similar effect as that by a nanocomposite gel electrolyte.

Namely, in a nanocomposite gel electrolyte which is a gelled ionic liquid previously mixed with conductive particles such as carbon fibers or carbon blacks, semiconductor particles or conductive particles are capable of playing a role of a transfer agent of electric charges. This enhances conductivity of the gel-like electrolyte composition. Therefore, it is possible to obtain photoelectric conversion characteristics that stand comparison with those in the case where a liquid electrolyte is used.

In contrast to this, in the present invention, the carbon nanotubes play a role of a transfer agent of electric charges, and the electrolyte finds its way between the carbon nanotubes. As a result, a similar effect as that of the case where a nanocomposite gel electrolyte is used is obtained in the electrolyte in the vicinity of the counter electrode. Therefore, the transfer speed of electrons becomes higher to offer high photoelectric conversion efficiency.

### BRIEF DESCRIPTION OF THE DRAWINGS

FIG. 1 is a schematic diagram showing one example of a cross-sectional structure of a photoelectric conversion element of the present invention.
FIG. 2 is an enlarged exterior perspective view conceptually showing a structure of a counter electrode of the present invention.
FIG. 3 is a drawing showing a cross-sectional structure of the counter electrode of the present invention.
FIG. 4 is a schematic cross-sectional view showing one example of a structure of a conventional photoelectric conversion element.

### DESCRIPTION OF THE REFERENCE SYMBOLS

1: counter electrode; 2: window electrode; 3: electrolyte layer; 4: sealant; 5: fill port for electrolyte solution; 10: photoelectric conversion element; 11: first substrate; 12: transparent conductive film; 13: carbon nanotube; 21: second substrate; 22: transparent conductive film; 23: porous semiconductor film

### BEST MODE FOR CARRYING OUT THE INVENTION

Hereunder is a description of a photoelectric conversion element and a counter electrode for the photoelectric conversion element of the present invention with reference to the drawings.

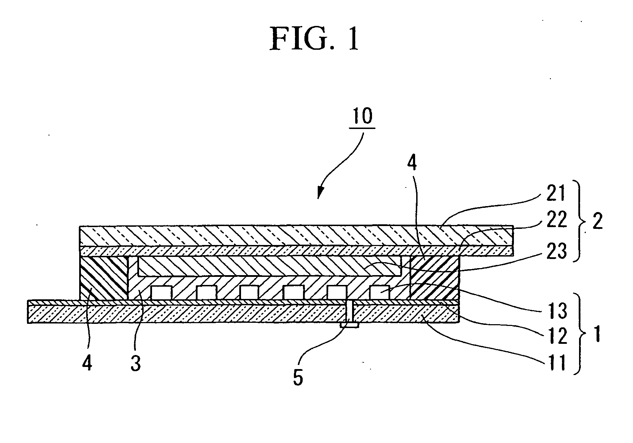

FIG. 1 shows a schematic diagram of one example of a structure of a photoelectric conversion element according to the present invention.

The photoelectric conversion element 10 of the present invention mainly comprises a counter electrode 1 formed with carbon nanotubes 13, a window electrode 2 formed with a porous semiconductor film 23 on which a sensitizing dye is adsorbed, and an electrolyte layer 3 encapsulated between them.

In the counter electrode 1, brush-like carbon nanotubes 13 are provided on a surface of a first transparent substrate 11 via a transparent conductive film 12 formed for imparting conductivity to the surface.

On the other hand, on the window electrode 2, for which a light transmissive second substrate 21 is used, a porous semiconductor film 23 is provided on which a sensitizing dye is adsorbed via a transparent conductive film 12 formed for imparting conductivity.

The window electrode and the counter electrode are spaced apart at a predetermined distance such that the brush-like carbon nanotubes 13 face the porous semiconductor film 23 on which the sensitizing dye is adsorbed. A sealant 4 made of a heat-curing resin is provided between the electrodes at the peripheral region. The electrodes are then attached to assemble a cell. Next, an electrolyte solution in which redox pairs including an iodine/iodide ion (I⁻/I³⁻) as electrolyte are dissolved in an organic solvent of acetonitrile is filled between the electrodes 1 and 2 via a fill port for the electrolyte solution to form an electrolyte layer 3 for transferring electric charges.

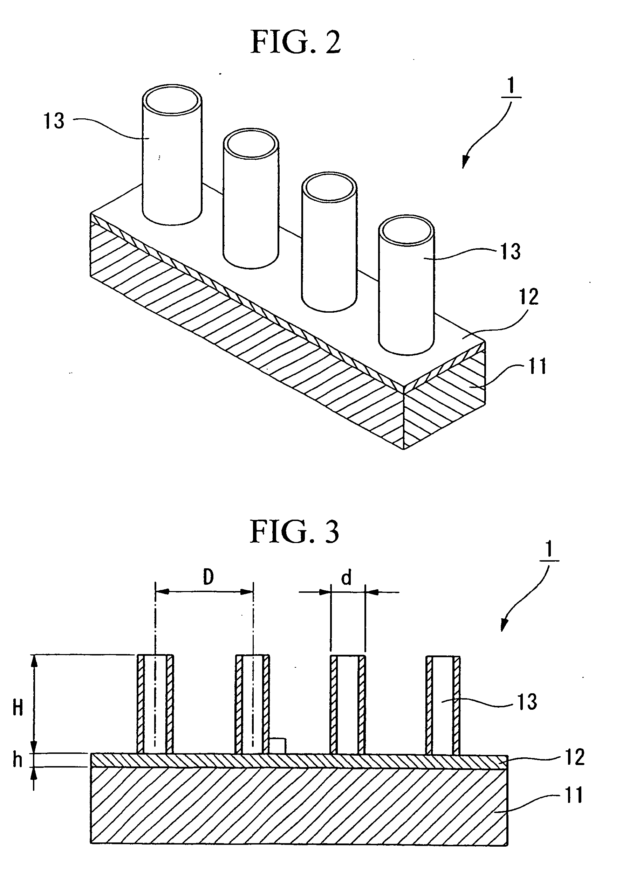

FIG. 2 conceptually shows enlarged exterior perspective view of a structure of the counter electrode 1 of the present invention. FIG. 3 schematically shows a - cross-sectional structure thereof. As shown in FIG. 2 and FIG. 3, in the counter electrode 1 of the present invention, the transparent conductive film 12 made of fluorine-doped tin oxide (FTO) with a thickness h of approximately 0.1 µm is formed on the surface of the first substrate 1 made of transparent glass, etc. for imparting conductivity. The surface of the transparent conductive film 12 has the carbon nanotubes 13. The carbon nanotubes 13 are formed in a brush-like shape with its one end being fixed on the transparent conductive film 12 provided on one surface of the first substrate 11. The growth direction of the carbon nanotubes 13 does not matter. However, it is especially preferable that the carbon nanotubes 13 be formed substantially perpendicular to the surface of the transparent conductive film 12.

With the counter electrode 1 configured as above, the electrolyte solution is filled between the individual carbon nanotubes 13, further improving conductivity of the iodine electrolyte solution.

The present invention is one that adopts carbon nanotubes in the counter electrode, instead of conventional carbon film or platinum film.

A carbon nanotube has a structure in which a graphite sheet is rolled up into a cylindrical shape, with a diameter of approximately 0.7 to 50 nm and a length of several micrometers. It is a hollow material with a very high aspect ratio. As for electric characteristics, the carbon nanotube shows metal-like to semiconductor-like characteristics depending on its diameter or chirality. As for mechanical characteristics, the carbon nanotube is a material having both of a high Young's modulus and a characteristic that is capable of relieving stress also by buckling. Furthermore, the carbon nanotube is chemically stable since it does not have a dangling bond, and is composed only of carbon atoms. Therefore, the carbon nanotube is seen as an environment-friendly material.

Owing to the unique physicality as described above, carbon nanotubes are expected to be applied to: an electron emission source or a flat panel display as an electron source; a nanoscale device or a material for an electrode of a lithium battery as an electronic material; a probe; a gas storage member; a nanoscale test tube; an additive for reinforcing a resin; or the like.

A carbon nanotube has a tubular structure in which a graphene sheet is formed in a cylindrical shape or a frustum-of-a-cone shape. More particularly, a single-wall carbon nanotube (SWCNT) that has a single graphene sheet layer, a multi-wall carbon nanotube (MWCNT) that has a plurality (two or more) graphene sheet layers, and the like are available. Any of these can be utilized for the counter electrode of the present invention.

A single-wall carbon nanotube is available with a diameter of about 0.5 nm to 10 nm and a length of about 10 nm to 1 µm. A multi-wall carbon nanotube is available with a diameter of about 1 nm to 100 nm and a length of about 50 nm to 50 µm.

As for a brush-like carbon nanotube 13 of the present invention shown in FIG. 3, one with a diameter d of approximately 5 to 75 nm, a height H of approximately 0.1 to 500 nm is appropriate. Furthermore it is appropriate for the distance D between the individual carbon nanotubes 13 to be approximately 1 to 1000 nm.

As is seen from the fact that it is applied to an emitter of an electron emission source, a carbon nanotube has high electron emission performance due to its shape with a high aspect ratio. This is because the emission of electrons occurs at the tip of the carbon nanotube. Thus, it is expected that orienting the carbon nanotube vertically will enhance capability of electron emission. Therefore, when the carbon nanotube is applied to a counter electrode of a photoelectric conversion element, it is possible to make the counter electrode favorable in photoelectric conversion efficiency.

Furthermore, by use of brush-like carbon nanotubes in the electrode, it is expected that the electrolyte will be facilitated to find its way between the carbon nanotubes, improving conductivity of the iodine electrolyte.

In the present invention, it is possible to obtain a similar effect as that by a nanocomposite gel electrolyte. Namely, in a nanocomposite gel electrolyte which is a gelled ionic liquid previously mixed with conductive particles such as carbon fibers or carbon blacks, semiconductor particles or conductive particles are capable of playing a role of a transfer agent of electric charges. This enhances conductivity of the gel-like electrolyte composition. Therefore, it is possible to obtain photoelectric conversion characteristics that stand comparison with those in the case where a liquid electrolyte is used.

In contrast to this, in the present invention, the carbon nanotubes play a role of a transfer agent of electric charges, and the electrolyte finds its way between the carbon nanotubes. As a result, a similar effect as that of the case where a nanocomposite gel electrolyte is used is obtained in the electrolyte in the vicinity of the counter electrode. Therefore, the transfer speed of electrons becomes higher to offer high photoelectric conversion efficiency.

It is possible to fabricate carbon nanotubes by a known chemical vapor deposition method (CVD method). For example, Japanese Unexamined Patent Application, First Publication No. 2001-220674 discloses as follows. After a metal such as nickel, cobalt, iron is deposited on a silicon substrate by sputtering or deposition, the substrate is heated under an inert atmosphere, a hydrogen atmosphere, or a vacuum atmosphere, preferably at a temperature of 500 to 900°C for 1 to 60 minutes. Subsequently, a general chemical vapor deposition (CVD) is performed for deposition with a hydrocarbon gas such as acetylene or ethylene, or an alcohol gas as a source gas. Then, carbon nanotubes with a diameter of 5 to 75 nm and a length of 0.1 to 500 µm grow on the silicon substrate.

When the brush-like carbon nanotubes are formed by the CVD method, it is possible to control the length and thickness of the brush-like carbon nanotubes by controlling the temperature and time in their fabrication.

It is preferable that the brush-like carbon nanotubes for use in the present invention have a diameter of 5 to 75 nm and a length of 0.1 to 500 µm, and that the distance between the carbon nanotubes be 1 to 1000 nm. When the diameters of the brush-like carbon nanotubes go out of the appropriate range, their aspect ratio becomes low, reducing electron emission capability. When the lengths of the brush-like carbon nanotubes go out of the appropriate range, it becomes difficult to orient them perpendicular to the substrate surface. When the distances between the brush-like carbon nanotubes are longer than the appropriate range, it becomes difficult to obtain a similar effect as that by a nanocomposite gel electrolyte.

As for the transparent base materials used as the first substrate 11 and the second substrate 21, substrates made of a light transmissive material are employed. Anything that is typically used for a transparent base material of a solar cell, such as glass, polyethylene terephthalate, polyethylene naphthalete, polycarbonate, and polyethersulfone, may be used. The transparent base material is appropriately selected from among these in consideration of its resistance to the electrolyte solution and the like. In view of its usage, a base material as excellent in light transmittance as possible is preferable, and a substrate with a transmittance of 90% or higher is more preferable.

The transparent conductive films 12 and 22 are thin films formed on one surface of the respective transparent substrates 11 and 21 for imparting conductivity to the substrates. In the present invention, the transparent conductive films 12 and 22 are preferably thin films made of conductive metal oxide to obtain a structure that does not significantly impair the transparency of the transparent substrates.

As for the conductive metal oxide, for example, indium tin oxide (ITO), fluorine-doped tin oxide (FTO), tin oxide (SnO₂), or the like may be used. Among these, ITO and FTO are preferable in view of easy deposition and inexpensive manufacturing cost. Furthermore, each of the transparent conductive films 12 and 22 may be a single layered film made only of ITO, or a laminated film in which an FTO film is stacked on top of an ITO film. With such a transparent conductive film, it is possible to configure a transparent conductive film that absorbs less light in the visible range and has a high conductivity.

In the counter electrode 1, the aforementioned brush-like carbon nanotubes are formed on the above-mentioned transparent conductive film 12 formed on the first substrate 11.

On the other hand, in the window electrode 2, the porous semiconductor film 23 made of oxide semiconductor fine particles such as of titanium oxide, on which a sensitizing dye is adsorbed, is formed on the above-mentioned transparent conductive film 22 formed on the second substrate 21.

The porous semiconductor film 23 is a porous thin film with a thickness of approximately 0.5 to 50 µm. Its main component is oxide semiconductor fine particles with an average particle size of 1 to 1000 nm, the particles being made of one or more of a mixture of at least two of titanium oxide (TiO₂), tin oxide (SnO₂), tungsten oxide (WO₃), zinc oxide (ZnO), niobium oxide (Nb₂O₅), and the like.

As for a method for forming the porous oxide semiconductor film 23, for example, one in which a desired additive is added as required to a dispersion liquid in which commercially-available oxide semiconductor fine particles are dispersed in a desired dispersion medium or to a colloid solution adjustable by the sol-gel process, followed by a coating of the liquid or the solution by a known method such as the screen print method, ink jet print method, roll coating method, doctor blade method, spin coat method, spray application method, or the like. In addition to this, other methods may be applicable such as: the electrophoretic deposition method that deposits oxide semiconductor fine particles onto an electrode substrate immersed in a colloid solution by electrophoresis; a method in which a colloid solution or dispersion liquid mixed with a foaming agent is coated on the substrate and then it is sintered for forming pores; a method in which a colloid solution or dispersion liquid mixed with polymer microbeads is coated on the substrate and then the polymer microbeads are removed by a heating treatment or chemical treatment to form cavities for forming pores.

The sensitizing dye adsorbed on the porous oxide semiconductor film 23 is not particularly limited. For example, the dye may be appropriately selected from among ruthenium complexes or iron complexes with a ligand including a bipyridine structure or terpyridine structure, metal complexes based on porphyrin or phthalocyanine, organic dyes such as eosin, rhodamine, merocyanine, and coumarin, depending on its usage and the material of the oxide semiconductor porous film.

For the electrolyte layer 3 encapsulated between the counter electrode 1 and the window electrode 2, a known electrolyte layer can be utilized. For example, the porous oxide semiconductor layer 23 impregnated with an electrolyte solution as shown in FIG. 1 can be listed. Alternatively, one in which the porous oxide semiconductor layer 23 and an electrolyte solution impregnated into the porous oxide semiconductor layer 23 is integrally formed after the electrolyte solution is gelled (quasi-solidified) by use of an appropriate gelling agent, a gel-like electrolyte including oxide semiconductor particles and conductive particles of ionic liquid, or the like can be listed.

As for the above electrolyte solution, one in which an electrolyte component such as iodine, iodide ion, and tertiary butylpyridine is dissolved into an organic solvent such as ethylene carbonate and methoxyacetonitrile is used.

As for a gelling agent used for gelling the electrolyte solution, poly(vinylidene fluoride), poly(ethylene oxide) derivative, amino acid derivative, and the like can be listed.

The above-mentioned ionic liquid is not particularly limited. As an example, an ambient temperature molten salt in which a compound that is a liquid at room temperature and has a quaternized nitrogen atom is cationized or anionized can be listed.

As for a cation of an ambient temperature molten salt, a quaternized imidazolium derivative, quaternized pyridinium derivative, quaternized ammonium derivative, and the like can be listed.

As for an anion of an ambient temperature molten salt, BF₄⁻, PF₆⁻, F(HF)n⁻, bis(trifluoromethylsulfonyl)imide(N(CF₃SO₂)₂⁻), iodide ion, and the like can be listed.

As specific examples of an ionic liquid, salts made of a quaternized-imidazolium-based cation and an iodide ion or a bis(trifluoromethylsulfonyl)imide ion and the like can be listed.

In the photoelectric conversion element of the present invention obtained by assembling the individual constituents mentioned above as shown in FIG. 1, brush-like carbon nanotubes with high electron emission capability are used in the counter electrode. Therefore, it has a high mobility of electrons from the counter electrode to the electrolyte. As a result, it is possible to obtain a photoelectric conversion element with high photoelectric conversion efficiency.

### EXAMPLES

### Examples 1 to 6

A photoelectric conversion element with a structure shown in FIG. 1 that has a counter electrode as in FIG. 2 and FIG. 3 was fabricated using the following materials.

### Electrolyte

As an electrolyte of Example 1, Example 3, and Example 4, an electrolyte solution made of an ionic liquid including iodine/iodide ion redox pairs (1-ethyl-3-imidazolium-bis(trifluoromethylsulfonyl)imide) was prepared.

As an electrolyte of Example 2, Example 5, and Example 6, a nanocomposite gel electrolyte that was made by mixing 10 wt% of oxide titanium nanoparticles with it, followed by centrifugal separation.

### Window Electrode

A glass substrate with an FTO film was used as a transparent electrode substrate. On a surface of the FTO film side of the transparent electrode substrate, a slurry-like dispersion solution of oxide titanium with an average particle size of 20 nm was coated. After it was dried, the substrate was subjected to a heating treatment at a temperature of 450°C for one hour to form an oxide semiconductor porous film with a thickness of 7 µm. Furthermore, the substrate was immersed in an ethanol solution of a ruthenium bipyridine complex (N3 dye) overnight for adsorption of the dye to fabricate a window electrode.

### Counter Electrode

In Example 1 and Example 2, a typical chemical vapor deposition method (CVD) that employs an acetylene gas as the source gas was used to form brush-like carbon nanotubes with a diameter of 10 to 50 nm and a length of 0.5 to 10 µm on a glass substrate with an FTO film to make a counter electrode. The carbon nanotubes were formed substantially perpendicular to the substrate. The distances between the individual carbon nanotubes were 10 to 50 nm.

In Example 3 and Example 5, a typical chemical vapor deposition method (CVD) that employs an acetylene gas as the source gas was used to form brush-like carbon nanotubes with a diameter of 10 to 50 nm and a length of 0.5 to 10 µm on a titanium plate to make a counter electrode. The carbon nanotubes were formed substantially perpendicular to the substrate. The distances between the individual carbon nanotubes were 10 to 50 nm. Note that as a titanium plate, one that was not subjected to an anodizing treatment was used in this example.

In Example 4 and Example 6, the counter electrode was fabricated in a similar manner as in Example 3, with the exception being that as a titanium plate, one that was subjected to an anodizing treatment was used.

The photoelectric conversion characteristics of the six types of photoelectric conversion elements thus fabricated were measured. The photoelectric conversion efficiencies are summarized in Table 1. CNT in Table 1 represents the aforementioned brush-like carbon nanotubes. In the column of Titanium plate anionization provided in Table 1, "Yes" represents the case where the treatment was performed, "No" represents the case where the treatment was not performed, and "--" represents the case that does not apply since the titanium plate was not used.

**Table 1**

| | Counter electrode structure | Titanium plate anionization | Electrolyte type | Conversion efficiency (%) |
|---|---|---|---|---|
| Example 1 | CNT/FTO | -- | Ionic liquid | 6.5 |
| Example 2 | CNT/FTO | -- | Nanocomposite gel | 6.5 |
| Example 3 | CNT/Ti plate | No | Ionic liquid | 6.6 |
| Example 4 | CNT/Ti plate | Yes | Ionic liquid | 6.8 |
| Example 5 | CNT/Ti plate | No | Nanocomposite gel | 6.4 |
| Example 6 | CNT/Ti plate | Yes | Nanocomposite gel | 6.6 |
| Comp. EX. 1 | Platinum/FTO | -- | Nanocomposite gel | 5.9 |
| Comp. EX. 2 | Platinum/FTO | -- | Ionic liquid | 5.1 |
| Comp. EX. 3 | Platinum/Ti plate | No | Ionic liquid | 5.1 |

### Comparative Example 1

As for the electrolyte, a nanocomposite gel electrolyte that was made by mixing 10 wt% of oxide titanium nanoparticles with it followed by centrifugal separation was used. For the counter electrode, a glass substrate with an FTO film formed with an electrode made of platinum by the sputtering method was employed. As for the window electrode, one similar to that in Examples was used.

A photoelectric conversion element with a structure shown in FIG. 4 was fabricated using such materials.

The photoelectric conversion characteristics of the photoelectric conversion element thus fabricated were measured. The photoelectric conversion efficiency is shown additionally in Table 1.

### Comparative Example 2

As for the electrolyte, the ionic liquid electrolyte solution similar to that in the above Examples was used. For the counter electrode, a glass substrate with an FTO film formed with an electrode film made of platinum by the sputtering method was employed, as in the above Comparative Example 1. As for the window electrode, one similar to that in Examples was used.

A photoelectric conversion element with a structure shown in FIG. 4 was fabricated using such materials.

The photoelectric conversion characteristics of the photoelectric conversion element thus fabricated were measured. The photoelectric conversion efficiency is additionally shown in Table 1.

### Comparative Example 3

As for the electrolyte, the ionic liquid electrolyte solution similar to that in the above Example 1 was used. For the counter electrode, a titanium plate formed with an electrode film made of platinum by the sputtering method was used, as in the above Comparative Example 1. As for the window electrode, one similar to that in Examples was used. Note that as a titanium plate, one that was not subjected to an anodizing treatment was used in this example.

A photoelectric conversion element with a structure shown in FIG. 4 was fabricated using such materials.

The photoelectric conversion characteristics of the photoelectric conversion element thus fabricated were measured. The photoelectric conversion efficiency is additionally shown in Table 1.

From the results in Table 1, the following points have become evident.
(1) Adopting a counter electrode that uses CNTs instead of conventional platinum enables increase in conversion efficiency by as much as 0.6 to 1.4%. This effect does not depend on the type of electrolyte (compare Example 1 with Comparative Example 2 and Example 2 with Comparative Example 1).
(2) Using a titanium plate instead of conventional FTO can also offer the effect of the above (1). This effect does not depend on the type of electrolyte (compare Example 1 with Example 3 and Example 2 with Example 5).
(3) When the titanium plate is used, it is possible to further increase conversion efficiency by performing an anionizing treatment. This effect does not depend on the type of electrolyte (compare Example 3 with Example 4 and Example 5 with Example 6).

From the above results, it has been confirmed that the photoelectric conversion element integrated with the carbon nanotubes according to the present invention has excellent photoelectric conversion efficiency.

When performing an anionizing treatment on the titanium plate, it is preferable that the thickness of the oxide layer formed by this treatment be 500 nm or less. When the thickness is more than 500 nm, flow of current from the CNTs synthesized on the oxide layer to the substrate (titanium plate) becomes less smooth, which is not favorable.

While preferred examples of the present invention have been described above, these are not considered to be limitative of the invention. Addition, omission, and replacement of the constituents, and other modifications can be made without departing from the scope of the invention. The present invention is not limited by the descriptions above, but is limited only by the appended claims.

## Claims

1. A solar cell (10), comprising:
a window electrode (2) having a transparent substrate (21) and a semiconductor layer (23) provided on a surface of the transparent substrate, a sensitizing dye being adsorbed on the semiconductor layer;
a counter electrode (1) having a substrate (11) and a conductive film (12), provided on a surface of the substrate, that is arranged so as to face the semiconductor layer of the window electrode; and
an electrolyte layer (3) disposed at least in a portion between the window electrode and the counter electrode, **characterized in that**:
the counter electrode (1) has brush-like carbon nanotubes (13) that are provided on the substrate surface (11) via the conductive film (12), and
the brush-like carbon nanotubes are oriented perpendicular to the substrate surface so as to directly connect to the electrolyte layer (3) disposed between the brush-like carbon nanotubes.

2. The solar cell (10) according to claim 1,
wherein the brush-like carbon nanotubes (13) have a diameter of about 5 to 75 nm and a length of about 0.1 to 500 µm.

3. The solar cell (10) according to claim 1 or claim 2,
wherein the brush-like carbon nanotubes(13) are spaced 1 to 1000 nm apart.

4. The solar cell (10) according to any one of claims 1 to 3, wherein the semiconductor layer (23) comprises a porous oxide semiconductor.

5. A solar cell (10), comprising:
a window electrode (2) having a transparent substrate (21) and a semiconductor layer (23) provided on a surface of the transparent substrate, a sensitizing dye being adsorbed on the semiconductor layer;
a counter electrode (1) including a titanium plate arranged so as to face the semiconductor layer (23) of the window electrode (2); and
an electrolyte layer (3) disposed at least in a portion between the window electrode and the counter electrode, **characterized in that**:
the counter electrode (1) has brush-like carbon nanotubes (13) that are provided on the substrate surface (11) via the titanium plate, and
the brush-like carbon nanotubes (13) are oriented perpendicular to the substrate surface so as to directly connect to the electrolyte layer (3) disposed between the brush-like carbon nanotubes.

## Patentansprüche

1. Solarzelle (10), die Folgendes umfasst:
eine Fensterelektrode (2) mit einem transparenten Substrat (21) und einer Halbleiterschicht (23), die auf einer Oberfläche des transparenten Substrats bereitgestellt ist, wobei ein Sensibilisierungsfarbstoff auf der Halbleiterschicht adsorbiert ist;
eine Gegenelektrode (1) mit einem Substrat (11) und einem leitfähigen Film (12), der auf einer Oberfläche des Substrats bereitgestellt ist, welche so angeordnet ist, dass sie der Halbleiterschicht der Fensterelektrode zugewandt ist; und
eine Elektrolytschicht (3), die zumindest in einem Abschnitt zwischen der Fensterelektrode und der Gegenelektrode angeordnet ist; **dadurch gekennzeichnet, dass**:
die Gegenelektrode (1) bürstenähnliche Kohlenstoffnanoröhrchen (13) aufweist, die auf der Substratoberfläche (11) durch den leitfähigen Film (12) hindurchverlaufend bereitgestellt sind, und
die bürstenähnlichen Kohlenstoffnanoröhrchen im rechten Winkel auf die Substratoberfläche ausgerichtet sind, um eine direkte Verbindung mit der Elektrolytschicht (3) herzustellen, die zwischen den bürstenähnlichen Kohlenstoffnanoröhrchen angeordnet ist.

2. Solarzelle (10) nach Anspruch 1,
worin die bürstenähnlichen Kohlenstoffnanoröhrchen (13) einen Durchmesser von etwa 5 bis 75 nm und eine Länge von etwa 0,1 bis 500 µm aufweisen.

3. Solarzelle (10) nach Anspruch 1 oder 2,
worin die bürstenähnlichen Kohlenstoffnanoröhrchen (13) 1 bis 1.000 nm voneinander beabstandet sind.

4. Solarzelle (10) nach einem der Ansprüche 1 bis 3, worin die Halbleiterschicht (23) einen porösen Oxidhalbleiter umfasst.

5. Solarzelle (10), die Folgendes umfasst:
eine Fensterelektrode (2) mit einem transparenten Substrat (21) und einer Halbleiterschicht (23), die auf einer Oberfläche des transparenten Substrats bereitgestellt ist, wobei ein Sensibilisierungsfarbstoff auf der Halbleiterschicht adsorbiert ist;
eine Gegenelektrode (1), die eine Titanplatte umfasst und so angeordnet ist, dass sie der Halbleiterschicht (23) der Fensterelektrode (2) zugewandt ist; und
eine Elektrolytschicht (3), die zumindest in einem Abschnitt zwischen der Fensterelektrode und der Gegenelektrode angeordnet ist; **dadurch gekennzeichnet, dass**:
die Gegenelektrode (1) bürstenähnliche Kohlenstoffnanoröhrchen (13) aufweist, die auf der Substratoberfläche (11) durch die Titanplatte hindurchverlaufend bereitgestellt sind, und
die bürstenähnlichen Kohlenstoffnanoröhrchen (13) im rechten Winkel auf die Substratoberfläche ausgerichtet sind, um eine direkte Verbindung mit der Elektrolytschicht (3) herzustellen, die zwischen den bürstenähnlichen Kohlenstoffnanoröhrchen angeordnet ist.

## Revendications

1. Pile solaire (10), comprenant :
une électrode fenêtre (2) comportant un substrat transparent (21) et une couche semi-conductrice (23) prévue sur une surface du substrat transparent, un colorant sensibilisant étant adsorbé sur la couche semi-conductrice ;
une contre-électrode (1) comportant un substrat (11) et un film conducteur (12), prévu sur une surface du substrat, qui est agencée de manière à faire face à la couche semi-conductrice de l'électrode fenêtre ; et
une couche d'électrolyte (3) disposée au moins dans une partie entre l'électrode fenêtre et la contre-électrode, **caractérisée en ce que** :
la contre-électrode (1) comporte des nanotubes de carbone de type brosse (13) qui sont prévus sur la surface du substrat (11) par l'intermédiaire du film conducteur (12), et
les nanotubes de carbone de type brosse sont orientés perpendiculairement à la surface du substrat de manière à être directement reliés à la couche d'électrolyte (3) disposée entre les nanotubes de carbone de type brosse.

2. Pile solaire (10) selon la revendication 1,
dans laquelle les nanotubes de carbone de type brosse (13) ont un diamètre d'environ 5 à 75 nm et une longueur d'environ 0,1 à 500 µm.

3. Pile solaire (10) selon la revendication 1 ou la revendication 2,
dans laquelle les nanotubes de carbone de type brosse (13) sont espacés de 1 à 1000 nm.

4. Pile solaire (10) selon l'une quelconque des revendications 1 à 3, dans laquelle la couche semi-conductrice (23) comprend un semi-conducteur à oxyde poreux.

5. Pile solaire (10), comprenant :
une électrode fenêtre (2) comportant un substrat transparent (21) et une couche semi-conductrice (23) prévue sur une surface du substrat transparent, un colorant sensibilisant étant adsorbé sur la couche semi-conductrice ;
une contre-électrode (1) comprenant une plaque de titane agencée de manière à faire face à la couche semi-conductrice (23) de l'électrode fenêtre (2) ; et
une couche d'électrolyte (3) disposée au moins dans une partie entre l'électrode fenêtre et la contre-électrode, **caractérisée en ce que** :
la contre-électrode (1) comporte des nanotubes de carbone de type brosse (13) qui sont prévus sur la surface du substrat (11) par l'intermédiaire de la plaque de titane, et
les nanotubes de carbone de type brosse (13) sont orientés perpendiculairement à la surface du substrat de manière à être directement reliés à la couche d'électrolyte (3) disposée entre les nanotubes de carbone de type brosse.
